# EUROPÄISCHE PATENTANMELDUNG

(11) **EP 0 949 583 A1**
(43) Veröffentlichungstag der Anmeldung: **13.10.1999**
(21) Anmeldenummer: 99810264.4
(22) Anmeldetag: 26.03.1999
(51) Int. Cl.: G06K 19/077

(54) **Elektronikobjekt**

(30) Priorität: 07.04.1998 CH 82098; 04.09.1998 EP 98810884
(71) Anmelder: ESEC Management SA, 6330 Cham (CH); Sempac SA, 6330 Cham (CH)
(72) Erfinder: Ragg, Wolfram, 6332 Hagendorn (CH); Sacher, Dieter, 5400 Baden (CH)

(57) **Zusammenfassung**

Das Elektronikobjekt (10) umfasst in einer ersten Ausführung einen Systemträger(14) zur Aufnahme eines Elektronikelementes und einen Körper (12) aus gespritztem Kunststoff. Der Systemträger (14) besitzt einen Aussenkontakt (16), der in einer Aussenfläche des Elektronikobjektes (10) liegt und über mindestens eine Abbiegung (19) mit dem Rest des Systemträgers (14) verbunden ist; er weist im Bereich dieser Abbiegung (19) an seiner äusseren Fläche (17) eine rückspringende Stufe (30) auf, deren Stufenoberkante (31) eine Grenze zwischen dem Kunststoff und dem Aussenkontakt (16) bildet.

Das Elektronikobjekt (10) umfasst in einer zweiten Ausführung einen Systemträger(14) mit einem Elektronikelement (40). Dieses ist von einer Kunststoffkapsel (44) umgeben, wobei der Kunststoff für die Kunststoffkapsel fliessfähig zugebracht wurde. Das Elektronikelement (40) ist in einer Vertiefung (34) des Systemträgers (14) montiert oder eine Vertiefung (34) im Systemträger (14) umgibt das Elektronikelement (40). Die durch die Vertiefung (34) im Systemträger (14) gebildete Stufe (30) bewirkt beim Aufragen des Kunststoffes zur Bildung der Kunststoffkapsel 44 das Stoppen des noch fliessenden Kunststoffes an der Vertiefung (34) und somit eine hohe Reproduzierbarkeit der Form und Grösse der Kunststoffkapsel (44).

## Beschreibung

Die Erfindung betrifft ein Elektronikobjekt.

Unter Elektronikobjekten im Sinne der Erfindung sollen Gegenstände verstanden werden, die mindestens ein Elektronikelement aufweisen, das in einem Körper aus Kunststoff eingebettet ist. Bei diesen Elektronikobjekten kann es sich um dünne, flache Gegenstände in der Art von Chipkarten oder um voluminösere Gegenstände in der Art von Anhängern, also sogenannten "tags", oder um Spielzeuge, Fernmeldegeräte oder elektrische Stecker, handeln. Das Elektronikelement kann beispielsweise ein Halbleiterchip, ein Ferritkern, ein Kondensator oder ein Widerstand sein, und es ist gewöhnlich an einem im Körper angeordneten Systemträger fixiert. Der Systemträger kann ein metallisches Leadframe oder ein Flextape oder eine Folie oder dergleichen sein, das mindestens eine Schicht aus nicht leitendem Material und mindestens eine strukturierte Metallschicht enthält. Der Körper besteht aus Kunststoff, der um bzw. an den Systemträger gespritzt ist. Der Systemträger befindet sich im wesentlichen innerhalb des Körpers, weist aber Aussenkontakte auf für die elektrische Verbindung zu einem externen Gerät, die bündig mit einer Aussenfläche des Elektronikelementes liegen. Die Aussenkontakte werden durch entsprechende Bereiche des Systemträgers gebildet, die im allgemeinen galvanisch behandelt sind, und die aus der Ebene, in welcher der Systemträger im wesentlichen angeordnet ist, ausgebogen sind. Bei allen Elektronikobjekten in der Art von Chipkarten und auch bei zahlreichen Elektronikobjekten mit voluminöseren Körpern sind die ausgebogenen Bereiche der Aussenkontakte des Systemträgers im allgemeinen über eine oder mehrere Biegungen bzw. Abkröpfungen mit dem Rest des Systemträgers verbunden, wobei die Aussenkontakte selbst häufig wieder parallel zur Ebene des Systemträgers angeordnet sind. Zur Herstellung des Körpers wird der Systemträger in einen Formhohlraum gebracht und darin so angeordnet und festgehalten, dass er mit den Aussenkontakten an einer Innenfläche des Formhohlraums anliegt. Anschliessend wird der Kunststoff in den restlichen Raum des Formhohlraums eingespritzt und ggfs. verdichtet und dann das fertige Elektronikobjekt dem Formhohlraum entnommen. In der Aussenfläche des fertigen Elektronikobjektes sind die Aussenkontakte und der den Körper bildende Kunststoff einander benachbart, und es wäre erwünscht, dass die Grenze zwischen jedem Aussenkontakt und dem Kunststoff einer genau definierten Linie, beispielsweise einer Geraden oder einer bestimmten, Kurve folgt. Weist das Elektronikobjekt mehrere Aussenkontakte auf, was im allgemeinen der Fall ist, so sollte nicht nur jede Grenze eines einzelnen Aussenkontaktes einer solchen definierten Linie folgen, sondern sämtliche Grenzen sollten sich auf einer definierten Linie, beispielsweise einer Geraden, einer Kreislinie oder einer anderen geometrisch bestimmten Linie, befinden.

Es hat sich nun herausgestellt, dass es gelegentlich schwierig ist, Elektronikobjekte herzustellen, welche die eben beschriebene Anforderung bezüglich solcher Grenzen zwischen den Aussenkontakten und dem Kunststoff des Körpers erfüllen. Der Grund dafür ist darin zu sehen, dass die Abbiegung bzw. Abkröpfung des Systemträgers am Übergang zu den Aussenkontakten eine gewisse Abrundung aufweist. Dies kann zur Folge haben, dass beim Spritzen des Körpers der Kunststoff im Bereich der abgerundeten Abbiegung etwa keilförmig und ziemlich zufällig zwischen die Begrenzungsfläche des Formhohlraums und den Systemträger dringt, was dann die weitere Folge haben kann, dass im fertigen Kunststoffobjekt die Grenze zwischen dem Kunststoff und den Aussenkontakten nicht wie angestrebt auf einer definierten Linie, beispielsweise einer Geraden oder einer Kreislinie, liegt.

Zwar könnte dies mindestens weitgehend behoben werden, wenn für die Abrundung der Abbiegung des Systemträgers ein sehr kleiner Biegeradius gewählt würde, doch sprechen verschiedene Gründe gegen die Wahl von solchen kleinen Biegeradien. Erstens besteht bei der Herstellung von Abbiegungen mit kleinen Biegeradien die Gefahr von Rissbildungen im Systemträger selbst. Zweitens haben scharf abgebogene Aussenkontakte die Neigung, sich in der Umgebung der Biegung zu Rinnen zu verformen, welche Rinnen im Querschnitt die Form von flachen U haben; solche Rinnen können sich dann bei der Herstellung des Körpers mit Kunststoff füllen. Dies ist bei vollständig im Kunststoff eingebetteten Teilen meistens unwesentlich, kann aber bei den an den Aussenflächen sichtbaren Aussenkontakten eventuell zu optisch unerwünschten, etwa halbmondförmig verlaufenden Grenzen zwischen den Aussenkontakten und dem Kunststoff des Körpers führen, was oft, insbesondere aus ästhetischen Gründen, unerwünscht ist. Drittens ergeben sich Probleme im Zusammenhang mit der Galvanisierung der Aussenkontakte; da nämlich eine Galvanisierung des Bereiches scharfer Abbiegungen nach der Herstellung der Abbiegungen problematisch sein kann, sollte die Galvanisierung an dem noch nicht deformierten Systemträger durchgeführt werden; dies bedeutet aber, dass dann nicht nur der Systemträger, sondern auch die auf ihm durch die Galvanisierung aufgebrachte Schicht gebogen werden muss, wobei in der galvanisierten Schicht kleinere Risse entstehen können; diese Risse beeinträchtigen zwar meistens die elektrische Funktion der Aussenkontakte nicht, bilden aber Zutrittswege zum Systemträger, durch welche Fremdstoffe aus der Umgebung dringen können, welche den Systemträger angreifen können. Wie oben dargelegt, kann also das Problem der nicht definierten Grenzen zwischen dem Kunststoff des Körpers und den Aussenkontakten durch die Wahl von kleinen Biegeradien für die Biegungen des Systemträgers nicht optimal behoben werden.

Ein weiteres Problem bei der Herstellung von Elektronikobjekten steht im Zusammenhang mit der Bestückung des Systemträgers mit Elektronikelementen. Um beispielsweise Halbleiterchips auf dem Systemträger zu befestigen, wird auf eine Chipinsel des Systemträgers eine klebende Schicht, beispielsweise ein Tropfen eines Klebers, aufgebracht. Auf diese klebende Schicht wird anschliessend der Halbleiterchip gebracht. Schliesslich wird der mit seiner Unterseite auf dem Systemträger haftende Halbleiterchip seitlich und oben durch eine Kunststoffkapsel umkapselt, welche aus einem Kunststoff hergestellt wird, der in fliessfähiger Form zugebracht wird und anschliessend erhärtet. Die auf diese Weise hergestellte Kunststoffkapsel tritt dabei an die Stelle des früher üblichen, durch ein Spritz- oder Giessverfahren in einer Form hergestellten Kunststoffgehäuses, mit welchem der Halbleiterchip umspritzt bzw. umgossen wurde. Die Herstellung einer solchen Kunststoffkapsel, für welche keine Form benötigt wird, ist offensichtlich einfacher und rationeller als die Herstellung des in einer Form gespritzten bzw. gegossenen Kunststoffgehäuses, doch besteht dabei die Gefahr, dass der in fliessfähiger Form zugebrachte Kunststoff nicht genügend rasch aushärtet bzw. bei zu geringer Viskosität seitlich wegfliesst, so dass keine einwandfreie Kunststoffkapsel entsteht. Um dies zu verhindern, wurde versucht, vor der Herstellung der Kunststoffkapsel auf dem Systemträger eine Art Erhöhung bzw. Damm aus einem anderen Kunststoff anzubringen, welcher eine sehr hohe Viskosität aufweist und/oder sehr rasch aushärtet. Eine auf diese Weise erzeugte Erhöhung hat den Nachteil einer zeitintensiven und, wegen des zusätzlich benötigten Kunststoffes, verhältnismässig teuren Herstellung.

Die Aufgabe der Erfindung wird somit darin gesehen, ein Elektronikobjekt der eingangs genannten Art zu schaffen, an dessen Aussenfläche der Übergang zwischen dem Kunststoff des Körpers und den Aussenkontakten präzis längs einer definierten Linie, beispielsweise einer Geraden, einer Kreislinie oder einer anderen bestimmten Kurve, verläuft. Eine weitere Aufgabe der Erfindung ist, ein Elektronikobjekt zu schaffen, bei welchem die das Elektronikelement umschliessende Kunststoffkapsel mit einer gut definierten Form in einfacher Weise hergestellt werden kann.

Diese Aufgaben werden erfindungsgemäss durch die Merkmale der Ansprüche 1 und 8 gelöst.

Der Systemträger des erfindungsgemässen Elektronikobjektes weist somit im Bereich des Beginns seiner Wegbiegung von der Aussenfläche des Elektronikobjektes eine Stufe auf. Die Stufe hat eine Tiefe von typisch 30 bis 50 µm. Diese Stufe mit einer längs einer definierten Linie verlaufenden Oberkante herzustellen, ist technisch gut möglich. Die Stufe springt von der dem Äusseren des Elektronikobjektes zugewandten Fläche des Systemträgers zum Inneren des Systemträgers zurück. Vom Äusseren des Elektronikobjektes aus gesehen, bildet die Oberkante der Stufe die Grenze zwischen dem Aussenkontakt und dem Kunststoff des Körpers. Der Biegeradius der Abbiegung des Systemträgers kann nun genügend gross gewählt werden, um die weiter oben beschriebenen Probleme kleiner Biegeradien zu vermeiden. Durch die Stufe im Systemträger erreicht man nämlich, dass sich der Systemträger am Beginn der Abbiegung sofort, Vorzugsweise unter einem Winkel von mindestens annähernd 90°, von der Aussenfläche des Elektronikobjektes entfernt, so, wie es der Fall wäre, wenn ein herkömmlicher Systemträger ohne Stufe, jedoch mit einer Abbiegung mit minimalem Biegeradius, verwendet würde. Durch die Stufe erhält man, wie angestrebt, eine definierte Grenze zwischen Aussenkontakten und Kunststoff. Durch die neue Form des Systemträgers lassen sich sämtliche weiter oben beschriebenen Nachteile herkömmlicher Systemträger vermeiden.

Die Linie, auf welcher die Grenze zwischen dem Kunststoff und jedem Aussenkontakt bzw. zwischen dem Kunststoff und benachbarten Aussenkontakten liegt, kann eine Gerade, eine Kreislinie oder eine beliebige andere vorbestimmte Kurve sein.

Vorzugsweise bildet die rückspringende Stufe die eine Begrenzung einer flächigen Vertiefung des Systemträgers, wobei die andere Begrenzung der Vertiefung durch eine entsprechende vorspringende Stufe gebildet wird. Alternativ könnte der Grund der Vertiefung schief auslaufen.

Die Vertiefung kann sowohl durch eine spanabhebende, galvanische oder laserbewirkte Abtragung oder durch eine Deformation wie beispielsweise eine Prägung der Oberfläche des Systemträgers erzeugt werden. Die Vertiefung kann vor oder nach der Biegung des Systemträgers erzeugt werden; mit einer Erzeugung der Vertiefung vor der Biegung erzielt man einen zusätzlichen Vorteil, nämlich eine infolge der verminderten Wandstärke bessere Biegbarkeit des Systemträgers.

Die Stufe kann auch dadurch erzeugt werden, dass ein Systemträger verwendet wird, welcher aus zwei miteinander verbundenen Folienteilen mit unterschiedlichen Wandstärken verwendet wird, wobei der Folienteil mit der grösseren Wandstärke die Aussenkontakte und der Folienteil mit der kleineren Wandstärke den ins Innere des Elektronikobjektes abgebogenen Bereich des Systemträgers bildet; der Systemträger kommt dabei während des Spritzens des Körpers so in den Formhohlraum bzw. später in das Elektronikobjekt zu liegen, dass der Übergang zwischen den Folienteilen die Stufenoberkante der rückspringenden Stufe bildet.

Das Elektronikobjekt kann auch so ausgebildet sein, dass es mindestens einen weiteren Aussenkontakt besitzt, der seriell mit dem mindestens einen erstgenannten Aussenkontakt angeordnet und beidseitig über weitere Biegungen mit dem Rest des Systemträgers verbunden ist. Der Systemträger kann dann so geformt sein, dass er im Bereich jeder Biegung eine weitere rückspringende Stufe aufweist, die so ausgebildet und angeordnet ist, wie die weiter oben beschriebene Stufe.

Elektronikobjekte mit mehreren seriell angeordneten Aussenkontakten sind vorzugsweise so ausgebildet, dass diese Aussenkontakte in verschiedenen Aussenflächen des Elektronikelementes angeordnet sind.

Die Aussenflächen des Elektronikobjektes bzw. die darin angeordneten Aussenkontakte können eben, einfach oder mehrfach gekrümmt sein.

Die Erhöhung, durch welche die Ausbreitung des fliessfähigen Kunststoffes und schliesslich die Kunststoffkapsel selbst begrenzt ist, besteht erfindungsgemäss aus einer Stufe, zu welcher ein entsprechender Bereich, beispielsweise ein Ringbereich, des Systemträgers verformt ist, welcher diejenige Fläche des Systemträgers umgibt, auf der der Halbleiterchip oder ggfs. ein anderes Elektronikelement befestigt ist; die Stufenunterkante liegt dabei in der Höhe der Fläche, auf der das Elektronikelement befestigt ist, so dass sich dieses in einer Vertiefung befindet.

Die Vertiefung kann in gleicher Weise, nämlich durch ein materialabtragendes oder materialdeformierendes Verfahren, hergestellt sein wie die weiter oben beschriebene Vertiefung im Bereich der Aussenkontakte des Systemträgers.

Im folgenden wird die Erfindung anhand von Ausführungsbeispielen ausführlich beschrieben.
Es zeigen:
- Fig. 1A: ein erstes in einem Formhohlraum angeordnetes Elektronikobjekt nach dem Stand der Technik, nach dem Spritzen des den Körper bildenden Kunststoffes, mit einem Systemträger, der Abbiegungen mit einem grossen Biegeradius aufweist, ausschnittweise, in einem Schnitt;
- Fig. 1B: das in Fig. 1A dargestellte Elektronikobjekt, in einer Ansicht seiner Frontseite;
- Fig. 2A: ein zweites Elektronikobjekt nach dem Stand der Technik, mit einem Systemträger, der Abbiegungen mit einem kleinen Biegeradius aufweist, in gleicher Darstellung wie Fig. 1A;
- Fig. 2B: das in Fig. 2A dargestellte Elektronikobjekt, in gleicher Darstellung wie Fig. 1B;
- Fig. 2C: das in den Fig. 2A und 2B dargestellte Elektronikobjekt, in einem Schnitt längs der Linie II - II der Fig. 2A;
- Fig. 3A: ein erstes Elektronikobjekt nach der Erfindung, in gleicher Darstellung wie die Fig. 1A und 2A;
- Fig. 3B: das in Fig. 3A dargestellte Elektronikobjekt, in gleicher Darstellung wie die Fig. 1B und 2B;
- Fig. 4: ein drittes Elektronikobjekt nach der Erfindung, wobei die Stufe am Übergang durch Teile des Systemträgers mit unterschiedlichen Wandstärken gebildet wird, in gleicher Darstellung wie die Fig. 1A, 2A und 3A;
- Fig. 5: ein viertes Elektronikobjekt nach der Erfindung, wobei die Grenze zwischen dem Kunststoff und den Aussenkontakten aufeiner Kreislinie liegt, in gleicher Darstellung wie Fig. 3A;
- Fig. 6: ein fünftes Elektronikobjekt nach der Erfindung, mit einem weiteren, seriell zum erstgenannten Aussenkontakt angeordneten Aussenkontakt, in gleicher Darstellung wie die Fig. 3A und 4;
- Fig. 7: ein sechstes Elektronikobjekt nach der Erfindung, mit insgesamt drei Aussenkontakten, in gleicher Darstellung wie die Fig. 3A, 4 und 6;
- Fig. 8: ein siebtes Elektronikobjekt nach der Erfindung, mit einem zylindrischen Körper, ausschnittweise, in einem Schnitt quer zu seiner Längsachse;
- Fig. 9: einen Systemträger mit einem auf ihm befestigten und von einer Kunststoffkapsel umgebenen, in einer Vertiefung angeordnetem Halbleiterchip, ausschnittweise, in einem Schnitt;
- Fig. 10: einen Systemträger mit einem auf ihm befestigten und von einer Kunststoffkapsel umgebenen, in einer Vertiefung angeordneten Halbleiterchip, ausschnittweise, in einem Schnitt, wobei die Vertiefung durch Entfernung einer Schicht des zweischichtigen Systemträgers gebildet ist, in gleicher Darstellung wie Fig. 9; und
- Fig. 11: einen Systemträger mit einem auf ihm befestigten und von einer Kunststoffkapsel umgebenen, Halbleiterchip, in einem Schnitt, wobei der Systemträger eine um den Halbleiterchip umlaufende Vertiefung aufweist.

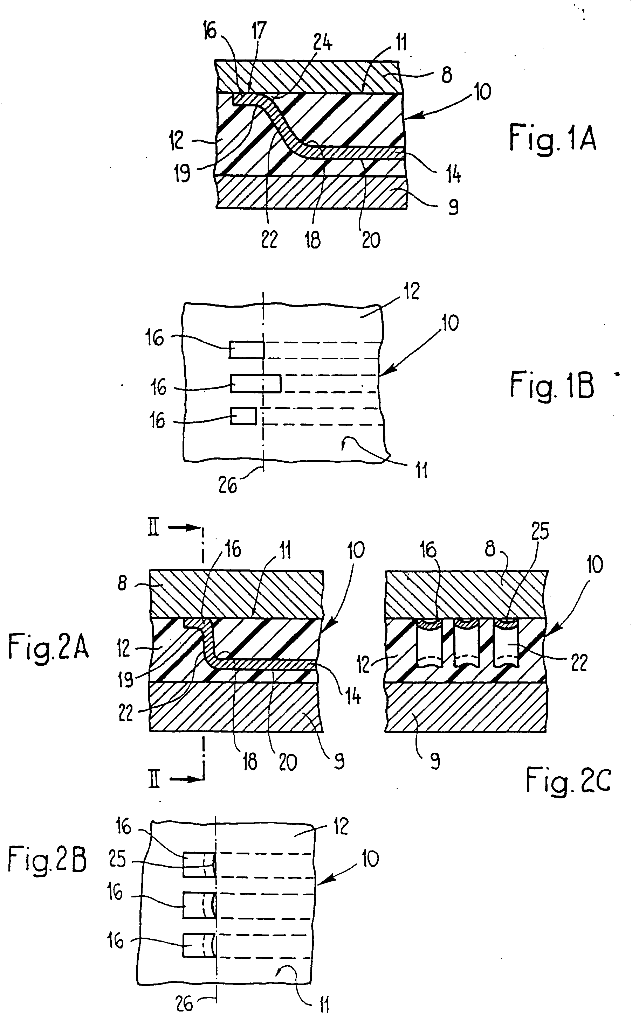

Fig. 1 zeigt ein in einem Formhohlraum, der durch zwei Formteile 8, 9 begrenzt ist, befindliches Elektronikobjekt 10 nach dem Stand der Technik. Das Elektronikobjekt 10 weist einen Körper 12 aus gespritztem Kunststoffund einen Systemträger 14 auf. Der Systemträger kann ein metallisches Leadframe oder ein Flextape sein, das eine strukturierte Metallschicht enthält. Der Systemträger 14 liegt im wesentlichen parallel zum Körper 12 des verhältnismässig dünnen Elektronikobjektes 10 und weist einen Randbereich mit mehreren Schlitzen auf (in Fig. 1 nicht sichtbar), die so mehrere getrennte Aussenkontakte 16 bilden, mittels derer das Elektronikobjekt 10 elektrisch mit einem externen Gerät verbunden werden kann. Drei Aussenkontakte 16 sind in der Fig. 1B gezeigt. Jeder Aussenkontakt 16 ist durch eine erste Biegung 18 und eine zweite Biegung 19 aus der Ebene des mittigen Bereiches 20 des Systemträgers 14 ausgebogen. Durch die Biegungen 18 und 19 werden eine Art Steg 22 und der Aussenkontakt 16 gebildet, wobei der Steg 22 quer und der Aussenkontakt 16 parallel zum mittigen Bereich 20 des Systemträgers 14 verlaufen. Die Biegungen 18 und 19 weisen verhältnismässig grosse Biegungsradien auf, und der Kunststoff des Körpers 12 bildet zwischen dem Formteil 8 und den Aussenkontakten 16 eine Art Keil 24. An der Aussenfläche 11 des Elektronikobjektes 10, die in Fig. 1 B sichtbar ist, sind die drei bündig mit dieser Aussenfläche liegenden Aussenkontakte 16 bzw. deren dem Äusseren des Elektronikobjektes 10 zugewandten Flächen 17 sichtbar. Infolge der zufälligen Formen und Abmessungen der Keile 24 liegen die Grenzen zwischen den Aussenkontakten 16 und dem Kunststoff des Körpers 12 nicht, wie es eigentlich erwünscht wäre, auf einer Geraden 26.

Die Fig. 2A, 2B und 2C zeigen ebenfalls ein Elektronikmodul 10 nach dem Stand der Technik, im wesentlichen gleich aufgebaut wie das in den Fig. 1A und 1B dargestellte Elektronikmodul, jedoch mit dem Unterschied, dass die Biegungen 18 und 19 verhältnismässig kleine Biegungsradien aufweisen. Dadurch vermeidet man zwar weitgehend die Bildung der Keile 24, dafür entstehen durch den Biegevorgang U-förmige rillenartige Deformationen 25 gemäss Fig. 2C im Bereich der Biegungen 18 und 19, welche sich bei der Herstellung des Körpers 12 mit Kunststoff füllen. Dies hat gemäss Fig. 2B zur Folge, dass bei solchen Elektronikobjekten 10 zwar die Grenzen zwischen den einzelnen Aussenkontakten 16 und dem Kunststoff des Körpers 12 nicht wesentlich gegeneinander versetzt sind, dass aber die Grenze jedes Aussenkontaktes 16 etwa halbmondähnlich verläuft, weil der Kunststoff die U-förmigen rillenartigen Deformationen 25 füllt.

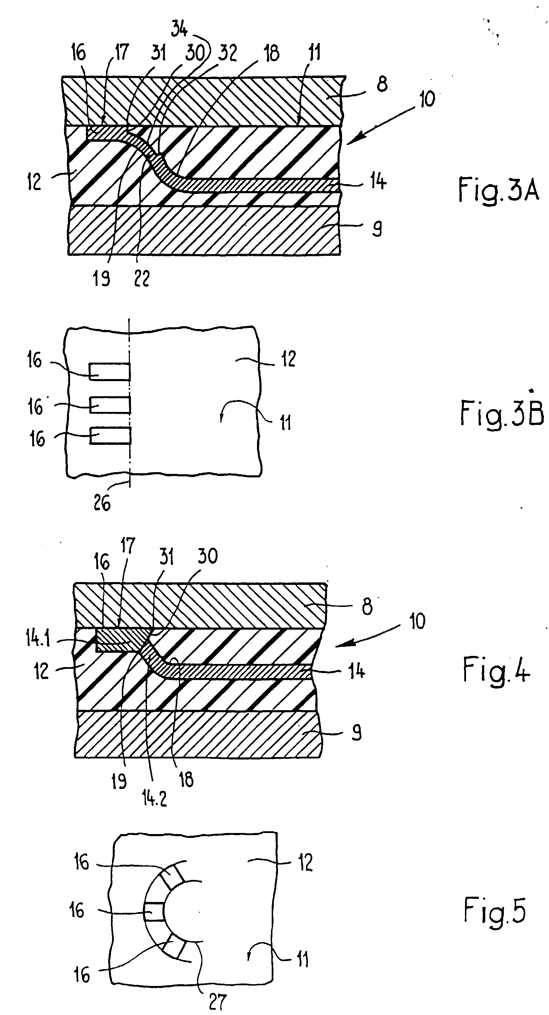

Fig. 3A zeigt ein Elektronikmodul 10 nach der Erfindung, mit einem Systemträger 14 in der Gestalt eines metallischen Leadframes. Im Bereich der Biegung 19, die an die Aussenkontakte 16 angrenzt, weist der Systemträger 14 eine von der dem Äusseren des Elektronikobjektes 10 zugewandten Fläche 17 rückspringende Stufe 30 auf. Diese Stufe 30 begrenzt zusammen mit einer weiteren, vorspringenden Stufe 32 im stegartigen Teil 22 des Systemträgers 14 eine flächige Vertiefung 34 im Systemträger 14, durch welche die Wandstärke des Systemträgers 14 örtlich verringert wird. Die Stufe 30 hat zur Folge, dass sich der Systemträger 14 praktisch unter einem rechten Winkel vom Formteil 8 entfernt, wobei die Stufenoberkante 31 eine genau definierte Begrenzung für den Kunststoff des Körpers 12 bildet, so dass an der Aussenfläche des fertigen Elektronikobjektes 10 die Grenze zwischen dem Kunststoff und den Aussenkontakten 16 auf die Gerade 26 zu liegen kommt, wie dies aus Fig. 3B ersichtlich ist.

Fig. 4 zeigt ein weiteres Elektronikobjekt 10 nach der Erfindung, das ähnlich ausgebildet ist wie das Elektronikobjekt der Fig. 3A und 3B. Im Unterschied zum Systemträger 14 des Elektronikobjektes 10 gemäss Fig. 3A und 3B, deren Wandstärke überall gleich ist, weist aber das Elektronikobjekt 10 gemäss Fig. 4 einen Systemträger 14 auf, der aus zwei miteinander verbundenen Folienteilen 14.1 und 14.2 besteht. Die Aussenkontakte 16 sind aus dem Folienteil 14.1 gebildet; wobei die Wandstärke des Folienteils 14.1 grösser ist als die Wandstärke des Folienteils 14.2. Der Systemträger 14 wird in diesem Fall so im Formhohlraum bzw. im fertigen Elektronikobjekt 10 angeordnet, dass die Stufe 30 durch den Übergang vom Folienteil 14.1 zum Folienteil 14.2 gebildet wird. Die Draufsicht auf das Elektronikobjekt 11 gemäss Fig. 4 ist dieselbe wie die in Fig. 3B dargestellte Draufsicht auf das Elektronikobjekt gemäss Fig. 3A.

In Fig. 5 ist ein weiteres Elektronikobjekt 10 dargestellt, dessen Aussenkontakte 16 in einem Kreisring liegen bzw. im Bereich ihrer Biegung durch einen Kreis 27 begrenzt sind.

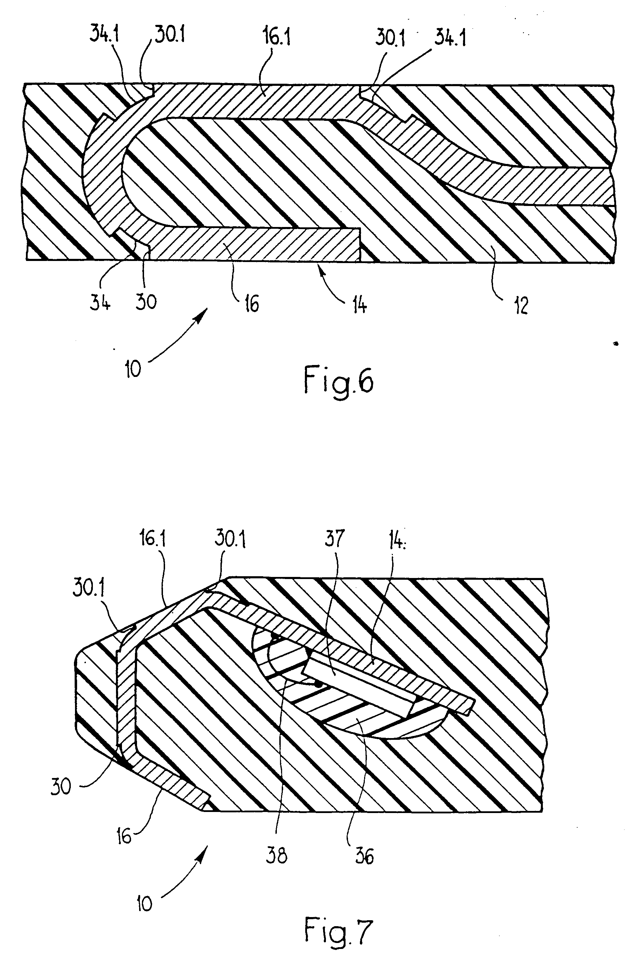

Fig. 6 zeigt ein Elektronikobjekt 10, das einen Systemträger 14 enthält, der so geformt ist, dass er zusätzlich zum Aussenkontakt 16 einen weiteren Aussenkontakt 16.1 aufweist, wobei die beiden Aussenkontakte 16, 16.1 an zwei gegenüberliegenden, einander parallelen Aussenflächen des Elektronikobjektes 10 angeordnet sind. Der Systemträger 14 weist angrenzend an den Ausserkontakt 16 die Stufe 30 bzw. die Vertiefung 34 und angrenzend an den Aussenkontakt 16.1 zwei Stufen 30.1 bzw. zwei Vertiefungen 34.1 auf. Das äussere Ende des Systemträgers 14 ist scharfkantig, so dass auch dort eine einwandfreie Grenze zwischen dem Kunststoff des Körpers 12 und jedem Aussenkontakt 16 entsteht.

Das in Fig. 7 dargestellte Elektronikobjekt 10 ist, im Gegensatz zu den chipkartenförmigen, flachen Elektronikobjekten der Fig. 3A bis 5, ein voluminöseres Elektronikobjekt. Es weist einen Systemträger 14 auf, der ebenfalls Aussenkontakte 16, 16.1 an zwei Aussenflächen des Elektronikelementes 10 bildet, wobei diese Aussenflächen nicht parallel, sondern unter einem gegenseitigen Winkel angeordnet sind. In Fig. 7 ist auch ein am Systemträger 14 fixierter, von einer Kunststoffkapsel 36 umgebener Halbleiterchip 37 mit seiner Kontaktierung 38 abgebildet. Die Stufen 30, 30.1 bzw. die Vertiefungen 34, 34.1 sind entsprechend den Stufen und Vertiefungen gemäss Fig. 6 ausgebildet und angeordnet.

Wenn der verwendete Systemträger ein Flextape ist, dann ist es möglich, dass die Aussenkontakte 16 und 16.1 galvanisch getrennt sind.

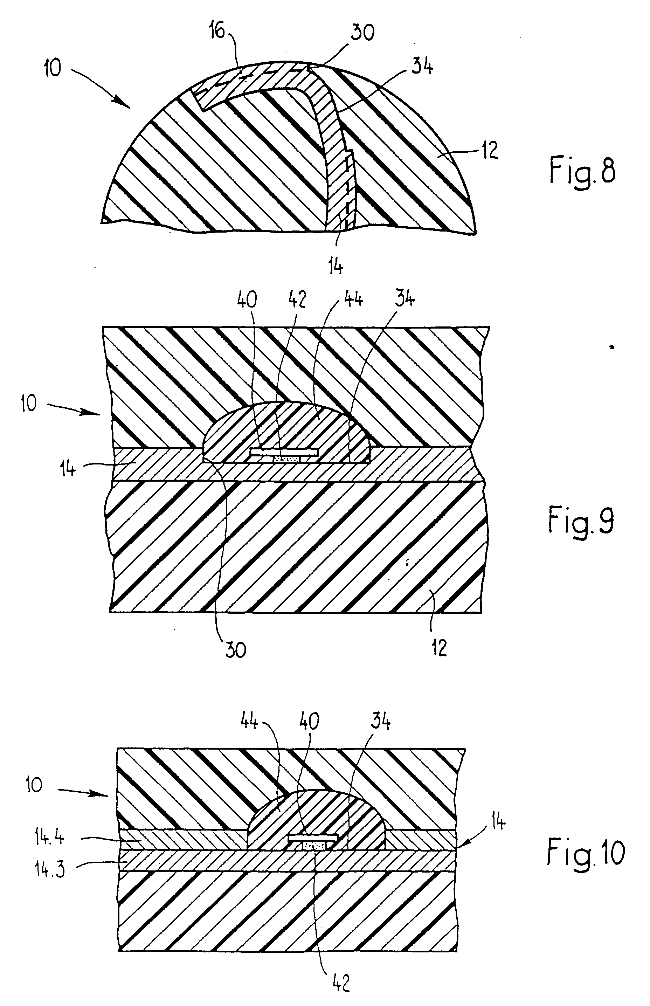

In Fig. 8 ist ein zylindrisches Elektronikobjekt 10 gezeigt, dessen Aussenkontakte 16 in Umfangsrichtung verlaufen und damit einfach gekrümmte Flächen bilden. Die Stufen 30 sind hier so angeordnet, dass sie annähernd radial ins Innere des Elektronikobjektes 10 zurückspringen. Grundsätzlich können auch Aussenkontakte 16 mit mehrfach gekrümmten Flächen mit Stufen ausgebildet werden.

Bei den bisher offenbarten Beispielen war der verwendete Systemträger 14 ein metallisches Leadframe. Wie früher erwähnt, kann der Systemträger 14 auch ein Flextape oder dergleichen sein, das wenigstens eine Schicht aus nichtleitendem Material und eine Schicht aus Metall enthält. In diesem Fall muss die Metallschicht, die die Aussenkontakte 16 enthält, in der oben beschriebenen Weise mit den Stufen 30, 32 bzw. der Vertiefung 34 versehen sein. Ein solches Beispiel ist in der Fig. 8 gezeigt: Der Systemträger kann das metallische Leadframe oder eine Folie sein, die, wie mit einer gestrichelten Linie markiert ist, aus einer nicht leitenden Schicht und einer metallischen Schicht besteht, wobei die Vertiefung 34 durch lokales Abtragen der metallischen Schicht gebildet wurde.

Das Prinzip der Erzeugung der einer definierten Linie folgenden Grenze für fliessfähig zugebrachten Kunststoff mit Hilfe von Stufen im Systemträger lässt sich bei Elektronikobjekten 10 bzw. Systemträgern 14 grundsätzlich überall anwenden. Als Beispiel zeigt Fig. 9 einen Systemträger 14 eines weiteren Elektronikobjektes 10 mit einem Körper 12. Ein Halbleiterchip 40 ist mittels einer klebenden Schicht 42 auf dem Systemträger 14 befestigt und von einer Kunststoffkapsel 44 umgeben. Der Halbleiterchip 40 ist in einer Vertiefung 34 des Systemträgers 14 montiert. Beim Auftragen des Kunststoffes in flüssiger Form zur Bildung der Kunststoffkapsel 44 stoppt der Kunststoff an der Stufe 30, die die Grenze der Vertiefung 34 bildet. Das von der anschliessend ausgehärteten Kunststoffkapsel belegte Gebiet 44 ist daher gut definiert und begrenzt auf das Gebiet der Vertiefung 34.

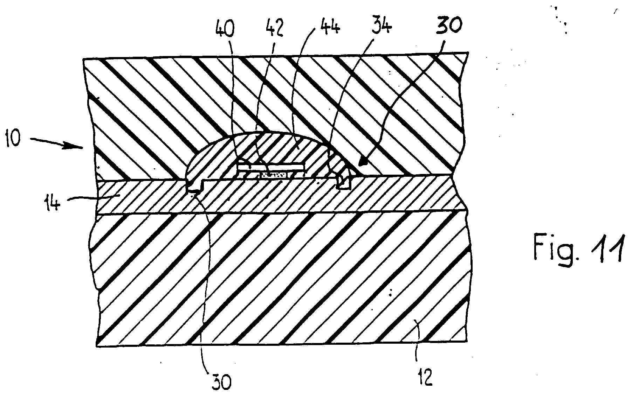

Fig. 10 zeigt einen Systemträger 14, welcher dem in Fig. 9 dargestellten Systemträger ähnlich ist, mit dem einzigen Unterschied, dass der Systemträger 4 hier aus zwei Schichten 14.3, 14.4 gebildet ist, und dass die Vertiefung 34 durch lokale Entfernung der Schicht 14.4 erzeugt ist.

Fig. 11 zeigt einen Systemträger 14, bei dem der Halbleiterchip 40 selbst nicht in einer Vertiefung angeordnet ist, bei der aber eine um den Halbleiterchip 40 umlaufende Vertiefung 34 vorhanden ist. Die durch die Vertiefung 34 im Systemträger 14 gebildete Stufe bewirkt beim Auftragen des Kunststoffes zur Bildung der Kunststoffkapsel 44 das Stoppen des noch fliessenden Kunststoffes an der Vertiefung und somit eine hohe Reproduzierbarkeit der Form und Grösse der Kunststoffkapsel 44. Der Systemträger 14 könnte auch hier aus zwei Schichten gebildet sein, wobei die Vertiefung 34 durch lokale Entfernung der obersten Schicht hergestellt ist.

## Patentansprüche

1. Elektronikobjekt (10), das wenigstens ein auf einem Systemträger (14) montiertes Elektronikelement und einen Körper (12) aus Kunststoff umfasst, wobei der Systemträger (14) mindestens einen Aussenkontakt (16) aufweist, der bündig mit einer Aussenfläche (11) des Körpers (12) liegt, **dadurch gekennzeichnet, dass** der Systemträger (14) auf seiner dem Äusseren des Elektronikobjektes (10) zugewandten Fläche (17) eine von dieser Fläche (17) zurückspringende Stufe (30) aufweist, deren Stufenoberkante (31) eine Grenze für den Kunststoff des Körpers (12) bildet.

2. Elektronikobjekt nach Patentanspruch 1, dadurch gekennzeichnet, dass der mindestens eine Aussenkontakt (16) über mindestens eine Abbiegung (19) mit einem anderen Bereich (20) des Systemträgers (14) verbunden ist und dass die Stufe (30) in der Nähe des Übergangs vom Aussenkontakt (16) zur Abbiegung (19) angeordnet ist.

3. Elektronikobjekt nach Patentanspruch 1 oder 2, dadurch gekennzeichnet, dass die Stufen (30) mehrerer benachbarter Aussenkontakte (16) derart gebildet sind, dass die Grenze zwischen den Aussenkontakten (16) und dem Kunststoff entlang einer definierten Linie verläuft.

4. Elektronikobjekt (10) nach Patentanspruch 1, 2 oder 3, dadurch gekennzeichnet, dass der Systemträger (14) aus zwei miteinander verbundenen Folienteilen (14.1, 14.2) gebildet ist, die unterschiedliche Wandstärken aufweisen, wobei die Folienteile (14.1, 14.2) so angeordnet sind, dass die rückspringende Stufe (30) beim Übergang vom Folienteil (14.1) grösserer Wandstärke zum Folienteil (14.2) geringerer Wandstärke gebildet ist.

5. Elektronikobjekt (10) nach mindestens einem der vorhergehenden Patentansprüche, dadurch gekennzeichnet, dass es mindestens einen weiteren, seriell mit dem mindestens einen Aussenkontakt (16) angeordneten Aussenkontakt (16.1) aufweist, der vorzugsweise in einer weiteren Aussenfläche des Elektronikobjektes (10) liegt und über Biegungen (19.1) mit dem Rest des Systemträgers (14) verbunden ist, wobei der Systemträger (14) im Bereich jeder der Biegungen (19.1) eine Stufe (30.1) aufweist.

6. Elektronikobjekt (10) nach mindestens einem der vorhergehenden Patentansprüche, dadurch gekennzeichnet, dass die Aussenkontakte (16) ebene oder ein- oder mehrfach gekrümmte Flächen bilden.

7. Elektronikobjekt (10) nach mindestens einem der vorhergehenden Patentansprüche, dadurch gekennzeichnet, dass die Aussenkontakte (16, 16.1) in verschiedenen Aussenflächen des Elektronikobjektes (10) angeordnet sind.

8. Elektronikobjekt (10), das einen Systemträger(14) und ein auf dem Systemträger (14) befestigtes Elektronikelement (40) umfasst, wobei das Elektronikelement (40) in eine Kunststoffkapsel (44) eingebettet ist, dadurch gekennzeichnet, dass das Elektronikelement (40) in einer Vertiefung (34) des Systemträgers (14) montiert ist oder dass eine Vertiefung (34) im Systemträger (14) das Elektronikelement (40) umgibt.
